# FASCICULE DE BREVET EUROPEEN

(11) **EP 3 719 947 B1**
(45) Date de publication et mention de la délivrance du brevet: **20.07.2022**
(21) Numéro de dépôt: 20167904.0
(22) Date de dépôt: 03.04.2020
(51) Int. Cl.: H02H 3/38, G01R 31/42, H02H 7/122, H02H 7/30

(54) **PROCÉDÉS ET SYSTÈMES DE PROTECTION ÉLECTRIQUE**
ELEKTRISCHE SCHUTZVERFAHREN UND - SYSTEME
ELECTRICAL PROTECTION METHODS AND SYSTEMS

(30) Priorité: 05.04.2019 FR 1903678
(43) Date de publication de la demande: 07.10.2020
(73) Titulaire: Schneider Electric Industries SAS, 92500 Rueil Malmaison (FR)
(72) Inventeur: NEYRET, Yannick, 38050 GRENOBLE Cedex 09 (FR)
(74) Mandataire: Lavoix

(56) Documents cités:
- EP-A2- 2 527 091
- DE-A1-102015 110 288
- DE-A1-102016 103 090
- DE-A1-102016 213 170

## Description

La présente invention se rapporte au domaine des réseaux de distribution d'électricité, et plus particulièrement aux micro-réseaux (nommés « microgrid » ou « nanogrid » en langue anglaise).

Les micro-réseaux sont généralement utilisés dans des bâtiments résidentiels, commerciaux ou industriels pour produire et stocker localement de l'électricité, tout en étant par ailleurs relié à un réseau public de distribution d'électricité.

Les micro-réseaux facilitent notamment l'utilisation de sources d'énergie distribuée, et plus particulièrement l'utilisation de sources d'énergie renouvelable, telles que des éoliennes, des hydroliennes ou des panneaux photovoltaïques. Les micro-réseaux peuvent également comporter des dispositifs de stockage d'énergie, tels que des batteries. Les micro-réseaux peuvent avantageusement être utilisés pour assurer une alimentation en électricité stable et continue lorsque le réseau public n'est pas assez fiable.

En pratique, les micro-réseaux servent à alimenter électriquement une ou plusieurs charges électriques qui sont protégées par des appareils de protection électrique, tels que des disjoncteurs ou des sectionneurs-fusibles, commandés à distance ou non.

Les micro-réseaux ont toutefois pour inconvénient qu'il est difficile de gérer les défauts électriques lorsque le micro-réseau est déconnecté du réseau public.

Il est notamment souhaitable de pouvoir rapidement isoler et localiser l'origine d'un défaut électrique, sans pour autant affecter l'alimentation électrique du reste du micro-réseau.

Typiquement, lorsqu'un micro-réseau est connecté au réseau public, ce dernier absorbe des variations ponctuelles de charge et assure la stabilité de la tension électrique en amplitude et en fréquence. De plus, en cas de défaut électrique de type court-circuit ou défaut d'isolement, le sur-courant résultant de ce défaut présente une valeur d'intensité élevée, par exemple de l'ordre de 10 à 20 fois la valeur d'intensité nominale de l'installation. Les appareils de protection électrique concernés par le défaut réagissent automatiquement et rapidement, ce qui permet d'isoler la partie du micro-réseau d'où provient le défaut électrique, sans affecter le fonctionnement du reste du micro-réseau.

Toutefois, lorsque le réseau public est déconnecté, un tel comportement n'est pas garanti.

Classiquement, de nombreux micro-réseaux incluent un groupe électrogène, en complément des systèmes de stockage d'énergie et des sources d'énergie renouvelable, ce qui a pendant longtemps donné satisfaction.

Généralement, un tel groupe électrogène comporte un moteur à combustion interne, tel qu'un moteur Diesel, couplé à une machine tournante, telle qu'un alternateur.

En particulier, lorsque le micro-réseau est déconnecté du réseau public, le groupe électrogène permet de stabiliser le micro-réseau et, en cas de défaut électrique, joue un rôle comparable à celui normalement joué par le réseau public, ce qui permet d'assurer un traitement satisfaisant du défaut électrique.

Toutefois, l'utilisation de groupes électrogènes Diesel dans des micro-réseaux n'est parfois plus souhaitée en raison de nouvelles normes environnementales et de contraintes règlementaires accrues. Il est alors nécessaire de pouvoir malgré tout assurer un comportement satisfaisant du micro-réseau en cas de défaut électrique.

En pratique, en l'absence de groupe électrogène, lorsque le micro-réseau est déconnecté du réseau public, l'alimentation électrique est assurée au moyen des onduleurs du dispositif de stockage d'énergie et des dispositifs de production d'énergie renouvelable, qui présentent toutefois un comportement différent de celui d'un alternateur d'un groupe électrogène, notamment parce que l'alternateur, de par sa construction, possède une inertie mécanique qui facilite la stabilisation du micro-réseau en cas de coupure et apporte un sur-courant significatif en cas de court-circuit.

En particulier, les sources d'énergie telles que les panneaux solaires sont en général des sources de courant qui sont asservies à la tension de la source de tension, la source de tension étant alors, dans un tel micro-réseau, constituée par l'onduleur du dispositif de stockage.

Un problème est qu'en cas de défaut électrique, l'onduleur du dispositif de stockage d'énergie ne peut maintenir l'alimentation que pendant une durée très courte, typiquement pendant au plus quelques secondes, avant de se mettre en défaut et de cesser d'alimenter le micro-réseau.

De plus, le sur-courant de l'onduleur présente une intensité très proche de la valeur d'intensité nominale, par exemple de l'ordre de 1,2 fois la valeur d'intensité nominale. Ce sur-courant est insuffisant, de par son intensité et par sa durée, pour garantir que les appareils de protection électrique les plus classiques, tels que les fusibles ou les disjoncteurs électromécaniques, seront effectivement déclenchés.

Il existe donc un risque que les appareils de protection ne puissent pas jouer leur rôle et que l'onduleur cesse d'alimenter le micro-réseau avant que le défaut électrique n'ait pu être localisé et isolé. Lorsque l'onduleur sera ensuite réarmé, le défaut sera toujours présent et conduira à nouveau à une défaillance du micro-réseau, ce qui complique donc considérablement la recherche et l'isolement du défaut par une équipe de maintenance.

Il existe aussi un risque que, du fait du temps de réaction élevé des appareils de protection dans de telles circonstances, le défaut électrique endommage le micro-réseau et engendre un départ d'incendie.

L'utilisation de dispositifs de protection contre les sur-courants dépendant de la tension, telle que les protections de type ANSI 51V, n'est pas toujours possible ni souhaitable dans les micro-réseaux, d'une part à cause du coût important de mise en oeuvre (car cela nécessite souvent l'adjonction d'un relais de protection électronique externe aux disjoncteurs) et d'autre part à cause de la complexité de leur installation et de leur paramétrage (car cela requiert des réglages de plusieurs paramètres additionnels pour chaque appareil de protection, le calcul de plans de protection spécifiques, ...) qui demandent beaucoup plus de temps et qui requièrent des compétences beaucoup plus poussées ou inhabituelles de la part des installateurs et des bureaux d'études en charge de l'installation et de la maintenance du micro-réseau.

Les documents suivants décrivent des exemples de systèmes de détection pour identifier un défaut électrique, mais ces systèmes ne concernent pas des micro-réseaux en premier lieu: DE 10 2016 213170 A1, EP 2527091 A2, DE 10 2016 103090 A1 et DE 10 2015 110288 A1.

Il existe donc un besoin pour une solution permettant de détecter des défauts électriques dans une installation électrique, notamment dans un micro-réseau et plus particulièrement un micro-réseau dépourvu de groupe électrogène Diesel, qui soit fiable, peu couteuse et facile à mettre en œuvre.

A cet effet, selon un aspect de l'invention, un procédé comportant la mise en œuvre, par un module électronique de surveillance associé à un appareil de protection électrique, d'étapes consistant à :
- mesurer, de façon répétée, une tension électrique et un courant électrique dans une liaison électrique à laquelle est associée ledit appareil de protection électrique ;
- calculer, de façon répétée, à partir des valeurs de courant mesurées, une première moyenne mobile et une deuxième moyenne mobile, la deuxième moyenne mobile étant calculée pour une durée plus longue que la première moyenne mobile ;
- comparer la valeur de tension mesurée avec une valeur seuil de tension prédéfinie ;
- comparer la valeur courante de la première moyenne mobile avec la valeur courante de la deuxième moyenne mobile ;
- identifier une condition de déclenchement de l'appareil de protection lorsque la valeur de tension mesurée est inférieure à la valeur seuil de tension prédéfinie pendant une durée supérieure à un seuil de durée prédéfini et que la valeur courante de la première moyenne mobile est supérieure à la valeur courante de la deuxième moyenne mobile.

L'utilisation des moyennes mobiles calculées à partir des valeurs de courant mesurées permet de détecter un défaut électrique avec un seuil de déclenchement qui s'adapte automatiquement en fonction des conditions de fonctionnement du réseau électrique dont font partie la liaison électrique et l'appareil de protection.

Grâce à l'invention, la détection d'un défaut électrique est donc réalisée de façon plus fiable et d'une façon relativement simple à mettre en œuvre.

Selon des aspects avantageux mais non obligatoires, un tel procédé peut incorporer une ou plusieurs des caractéristiques suivantes, prises isolément ou suivant toute combinaison techniquement admissible :
- Le procédé comporte en outre l'émission, par le module électronique de surveillance, d'un signal d'avertissement lorsqu'une condition de déclenchement est identifiée.
- Le procédé comporte l'émission, par le module électronique de surveillance, d'un signal de déclenchement à destination de l'appareil de protection lorsqu'une condition de déclenchement est identifiée.
- Le procédé comporte en outre, lorsqu'une condition de déclenchement est identifiée, l'enregistrement en mémoire, par le module électronique de surveillance, d'une variable d'état indiquant la présence d'une condition de déclenchement et, du démarrage du module électronique de surveillance, une condition de déclenchement étant identifiée si la variable d'état enregistrée en mémoire indique la présence d'une condition de déclenchement.
- Lorsqu'une condition de déclenchement est identifiée, le procédé comporte en outre des étapes consistant à attendre pendant une durée prédéfinie puis mesurer à nouveau une valeur de la tension électrique, la condition de déclenchement étant inhibée si la valeur mesurée de la tension électrique est inférieure à la valeur seuil de tension électrique.
- Le procédé comporte en outre :
   - l'acquisition d'une information d'état émise par un deuxième module électronique de surveillance semblable audit module électronique de surveillance, ce deuxième module électronique de surveillance étant associé à un deuxième appareil de protection connecté en aval dudit appareil de protection sur la même liaison électrique ;
   - l'inhibition de la condition de déclenchement pour ledit appareil de protection si l'information d'état acquise indique qu'une condition de déclenchement a été identifiée par le deuxième module électronique de surveillance pour le deuxième appareil de protection.
- La première moyenne mobile est calculée pour une première durée inférieure ou égale à 1 seconde, de préférence inférieure ou égale à 500ms et la deuxième moyenne mobile est calculée pour une deuxième durée supérieure à la première durée, de préférence au moins cinq fois supérieure à la première durée, la deuxième durée étant par exemple inférieure ou égale à 10 secondes, ou inférieure ou égale à 5 secondes.

Selon un autre aspect, l'invention concerne un système comportant un appareil de protection électrique et un module électronique de surveillance associé à l'appareil de protection électrique, le module électronique de surveillance étant programmé pour mettre en oeuvre des d'étapes consistant à :
- mesurer, de façon répétée, une tension électrique et un courant électrique dans une liaison électrique à laquelle est associée ledit appareil de protection électrique ;
- calculer, de façon répétée, à partir des valeurs de courant mesurées, une première moyenne mobile et une deuxième moyenne mobile, la deuxième moyenne mobile étant calculée pour une durée plus longue que la première moyenne mobile ;
- comparer la valeur de tension mesurée avec une valeur seuil de tension prédéfinie ;
- comparer la valeur courante de la première moyenne mobile avec la valeur courante de la deuxième moyenne mobile ;
- identifier une condition de déclenchement de l'appareil de protection lorsque la valeur de tension mesurée est inférieure à la valeur seuil de tension prédéfinie pendant une durée supérieure à un seuil de durée prédéfini et que la valeur courante de la première moyenne mobile est supérieure à la valeur courante de la deuxième moyenne mobile.

Selon des aspects avantageux mais non obligatoires, un tel système peut incorporer une ou plusieurs des caractéristiques suivantes, prises isolément ou suivant toute combinaison techniquement admissible :
- Le module électronique de supervision est intégré à l'appareil de protection, par exemple implémenté par un déclencheur électronique de l'appareil de protection.
- Le module électronique de supervision est séparé de l'appareil de protection et monté à l'extérieur de l'appareil de protection.

Selon encore un autre aspect, l'invention concerne un réseau électrique notamment un micro-réseau, comportant :
- un dispositif de stockage d'électricité et/ou un dispositif de génération d'électricité, alimentant une liaison principale ;
- au moins une charge électrique, connectée à la liaison principale par l'intermédiaire d'un système de protection tel que décrit précédemment.

L'invention sera mieux comprise et d'autres avantages de celle-ci apparaîtront plus clairement à la lumière de la description qui va suivre d'un mode de réalisation d'un tel procédé donnée uniquement à titre d'exemple et faite en référence aux dessins annexés, dans lesquels :
[Fig 1] la figure 1 est une représentation schématique d'un exemple d'un réseau de distribution électrique ;
[Fig 2] la figure 2 est une représentation schématique d'un module électronique de surveillance conforme à des modes de réalisation de l'invention associé à un appareil de protection électrique du réseau de la figure 1 ;
[Fig 3] la figure 3 est un diagramme de flux d'un exemple d'un procédé de fonctionnement du module électronique de surveillance de la figure 2 selon un premier mode de réalisation ;
[Fig 4] la figure 4 est un chronogramme d'un premier exemple de fonctionnement du module électronique de surveillance de la figure 2 ;
[Fig 5] la figure 5 est un chronogramme d'un deuxième exemple de fonctionnement du module électronique de surveillance de la figure 2 ;
[Fig 6] la figure 6 est un diagramme de flux d'un exemple d'un procédé de fonctionnement du module électronique de surveillance de la figure 2 selon un deuxième mode de réalisation.

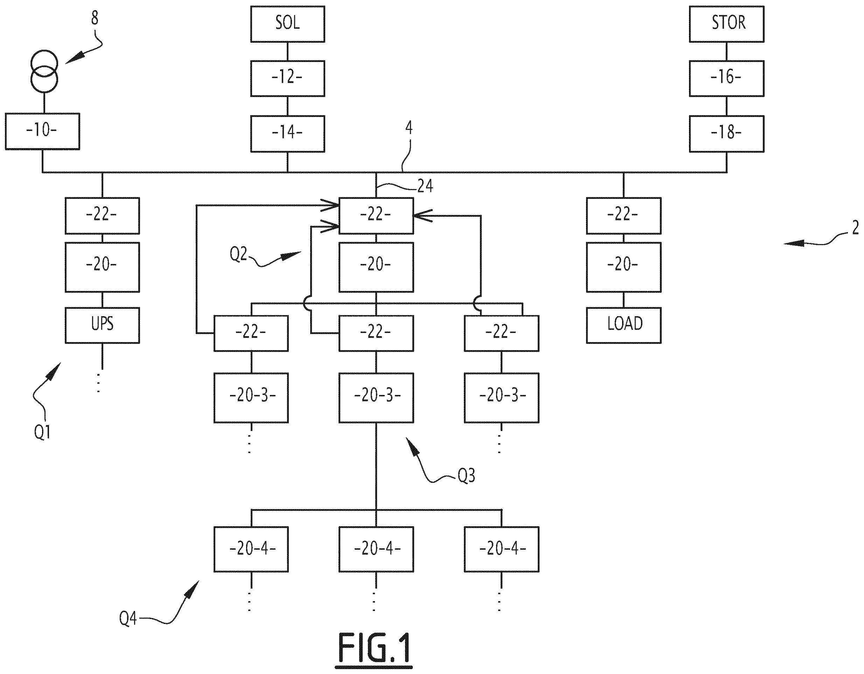

Sur la figure 1 est représenté schématiquement un exemple d'un réseau de distribution électrique 2, tel qu'un micro-réseau.

Le réseau 2 comprend une liaison électrique principale 4 ici connectée à un réseau principal de distribution 8, tel qu'un réseau public de distribution d'électricité, ici par l'intermédiaire d'un appareil de protection 10 tel qu'un disjoncteur.

Par exemple, la liaison électrique 4 comporte des conducteurs électriques, tels que des câbles ou des jeux de barres d'un tableau électrique.

Le réseau principal 8 est apte à fournir une alimentation électrique et peut être sélectivement déconnecté du réseau 2.

Selon des exemples, le réseau 2 est installé dans une installation résidentielle, commerciale ou industrielle.

Le réseau 2 comporte un ou plusieurs dispositifs de production d'électricité, préférentiellement des sources d'énergie renouvelable, telles que des éoliennes, des hydroliennes ou des panneaux photovoltaïques, et un ou plusieurs dispositifs de stockage d'énergie, tels que des batteries électriques.

Dans l'exemple illustré, le réseau 2 comporte :
- une source photovoltaïque SOL connectée à la liaison principale 4 par l'intermédiaire d'un onduleur 12 et d'un appareil de protection 14, et
- un dispositif de stockage d'énergie STOR connecté à la liaison principale 4 par l'intermédiaire d'un onduleur 16 et d'un appareil de protection 18.

De préférence, le réseau 2 est dépourvu de groupe électrogène, tel qu'un groupe électrogène Diesel ou, plus généralement, de tout générateur d'électricité comportant une machine tournante, tel qu'un alternateur. Dans le cas où un tel groupe électrogène serait physiquement présent dans le réseau 2, le groupe électrogène est préférentiellement déconnecté du réseau 2 ou maintenu dans un état arrêté.

Le réseau 2 comporte également une ou plusieurs charges électriques destinées à être alimentées électriquement grâce à l'électricité délivrée par le réseau principal 8 et/ou par le dispositif de stockage et/ou de production.

Les charges électriques sont connectées à la liaison d'alimentation principale 4 par l'intermédiaire d'appareils de protection électrique 20, tels que des disjoncteurs ou des sectionneurs-fusibles, commandés à distance ou non, ou tout appareil de protection équivalent.

Par exemple, chaque appareil de protection 20 est, de façon connue, configuré pour interrompre la circulation du courant électrique dans une liaison électrique du réseau 2 lorsque l'intensité électrique y circulant est supérieure à un seuil de déclenchement conformément à l'état de l'art.

Notamment, chaque appareil de protection est commutable entre un état électriquement ouvert, empêchant la circulation du courant, et un état électriquement fermé, autorisant la circulation du courant.

Selon des exemples d'implémentation, l'appareil de protection 20 est de technologie électromécanique et peut comprendre des contacts électriques séparables, ou tout autre moyen de coupure électrique, éventuellement commutables au moyen d'un actionneur pilotable, par exemple un actionneur électromagnétique.

Le réseau 2 comporte également des modules électroniques de surveillance 22 associés à un ou plusieurs des appareils de protection 20 et dont le rôle est décrit plus en détail dans ce qui suit.

Dans l'exemple illustré, un premier groupe de charges électriques, telles que des charges d'importance critique, désignées par la référence Q1, sont connectées à la liaison d'alimentation principale 4 par exemple par l'intermédiaire d'une alimentation sans interruption UPS (« uninterruptible power supply » en langue anglaise) et d'un premier appareil de protection 20 équipé d'un module de surveillance 22.

Un deuxième groupe de charges électriques LOAD est connecté à la liaison d'alimentation principale 4 par l'intermédiaire d'un deuxième appareil de protection 20 équipé d'un module de surveillance 22.

Un troisième groupe de charges électriques est connecté à la liaison d'alimentation principale 4 par l'intermédiaire de plusieurs appareils de protection 20 montés en cascade, ici au moyen de liaisons d'alimentation secondaires connectées en parallèle, par exemple disposées de façon hiérarchisée.

Par exemple, la référence 24 désigne la liaison d'alimentation secondaire à laquelle est associé un appareil de protection 20 de tête, désigné ici par la référence Q2, ce dernier formant un premier niveau de la hiérarchie du micro-réseau 2.

En aval de l'appareil de protection 20 de tête, la liaison d'alimentation secondaire 24 est partagée en trois branches comportant chacune un appareil de protection 20 ainsi qu'un module de surveillance 22 associé à un appareil de protection 20, formant ici un deuxième niveau.

Sur la figure 1, les appareils de protection 20 du deuxième niveau sont désignés par la référence « 20-3 » et l'un d'eux est ici désigné par la référence Q3.

Une ou plusieurs charges électriques peuvent être connectées directement ou indirectement en aval des appareils de protection du niveau Q3.

Toujours dans l'exemple illustré, l'une de ces branches est, en aval de son appareil de protection 20, elle-même subdivisée en trois autres branches auxquelles sont connectées, pour chacune d'entre elles, une ou plusieurs charges électriques par l'intermédiaire d'un appareil de protection 20, qui ici ne comporte pas module de surveillance 22, définissant un troisième niveau.

Sur la figure 1, les appareils de protection 20 du troisième niveau sont désignés par la référence « 20-4 » et l'un d'eux est ici désigné par la référence Q4.

Pour faciliter la lecture de la figure 1, les charges électriques ne sont pas toutes illustrées et les portions masquées du réseau 2 sont schématisées par des pointillés.

On comprend que le réseau 2 décrit en référence à la figure 1 est donné à titre d'exemple non nécessairement limitatif et, qu'en variante, le réseau 2 pourrait être différent, par exemple pourrait présenter une architecture et/ou une topologie différentes, et/ou comporter des charges électriques et des dispositifs de production et/ou des dispositifs de stockage différents, tant par leur nature que par leur nombre et leur disposition dans le réseau 2. Toutefois, l'invention concerne en premier lieu les applications dans lesquelles les sources d'énergie sont raccordées à la liaison d'alimentation 4 et ne sont pas disposées en aval d'appareils de protection 20.

Selon certains modes de mise en œuvre, comme dans l'exemple illustré, les appareils de protection 20 ne sont pas tous équipés d'un module de surveillance 22.

En pratique, dans des variantes préférées, seuls les appareils de protection 20 dont le calibre en courant Iₙ est supérieur ou égal à environ le dixième de l'intensité électrique nominale de l'onduleur 16 du dispositif de stockage d'énergie sont équipés d'un module de surveillance 22.

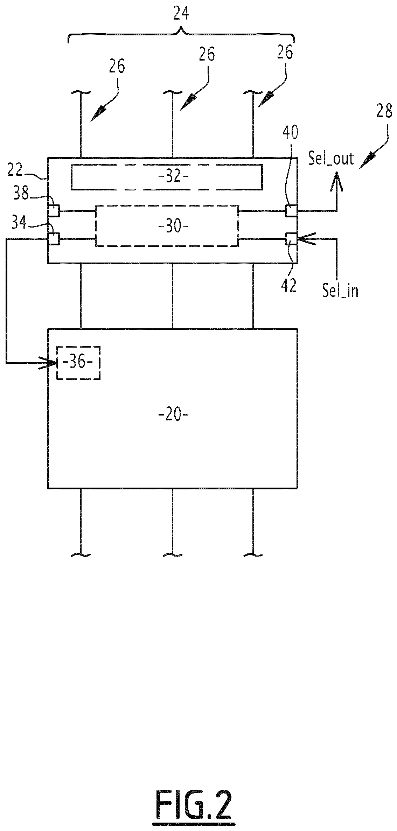

La figure 2 représente un des modules de surveillance 22 associé à un des appareils de protection 20, par exemple en étant monté sur la liaison d'alimentation électrique sur lequel est connecté l'appareil de protection 20.

Dans l'exemple illustré, la liaison d'alimentation 24 est une liaison triphasée et comporte trois conducteurs électriques 26 chacun associé à une phase électrique.

Selon d'autres variantes, non illustrées, les modes de réalisation décrits ci-après sont généralisables à d'autres types de réseaux, tels que des réseaux monophasés à deux conducteurs (neutre et phase), des réseaux biphasés à deux conducteurs (deux phases) ou à trois conducteurs (deux phases et neutre), ou encore à des réseaux triphasés à quatre conducteurs (trois phases et neutre).

L'appareil de protection 20 est ainsi adapté pour interrompre un courant électrique triphasé circulant dans ces conducteurs 26.

La référence 28 désigne le système formé par l'association de l'appareil de protection 20 et du module de surveillance 22.

Par exemple, les modules de surveillance 22 du réseau 2 sont similaires ou identiques entre eux et ont un fonctionnement similaire.

Le module de surveillance 22 comporte une unité électronique de traitement 30, un ensemble de capteurs 32 pour mesurer des valeurs de courant et de tension électriques dans la liaison d'alimentation 24, et une interface de communication.

Selon des modes de mise en œuvre, l'unité électronique de traitement 30 comporte une unité logique de calcul, telle qu'un microcontrôleur programmable ou un microprocesseur, et une mémoire informatique formant un support d'enregistrement de données lisible par ordinateur.

Par exemple, la mémoire est une mémoire ROM, ou une mémoire RAM, ou une mémoire non volatile de type EPROM, ou EEPROM, ou FLASH, ou NVRAM, ou une mémoire optique ou magnétique.

La mémoire comporte ici des instructions exécutables ou des modules de code logiciel, de préférence adaptées pour mettre en œuvre un procédé de détection tel que décrits dans les exemples qui suivent lorsque ces instructions sont exécutées par l'unité logique de calcul.

En variante, l'unité électronique de traitement 30 comporte un composant logique programmable de type FPGA ou un circuit intégré dédié de type ASIC configuré pour mettre en œuvre le procédé de détection.

Selon des modes de mise en œuvre, les capteurs 32 permettent de mesurer l'intensité du courant électrique qui circule dans la liaison d'alimentation à laquelle est associé le module de surveillance 22, par exemple pour mesurer l'intensité du courant dans chacune des phases 26.

Les capteurs 32 permettent également de mesurer la tension électrique entre deux phases 26 et/ou sur une ou plusieurs phases 26 individuelles, par exemple par rapport à un potentiel électrique de référence.

Par exemple, l'ensemble de capteurs 32 comporte un ou plusieurs capteurs de courant et un ou plusieurs capteurs de tension. Les capteurs de courant peuvent inclure un tore de Rogowski, ou un transformateur de courant, ou un capteur à effet Hall, ou un capteur de mesure par dérivation, aussi nommé « shunt ». Les capteurs de tension peuvent inclure, entre autres, un shunt, ou un transformateur de tension, ou un capteur capacitif.

L'interface de communication comporte par exemple une première sortie 34 pour envoyer un signal de commande de déclenchement à destination de l'appareil de protection 20, par exemple vers l'actionneur 36 ou vers un déclencheur de l'appareil de protection 20, notamment pour commuter l'appareil de protection 20 vers un état ouvert en cas de détection d'un défaut électrique.

Avantageusement, le module de surveillance 22 est également connecté à l'appareil de protection 20 pour déterminer l'état ouvert ou fermé de l'appareil de protection 20.

Selon des exemples, l'interface de communication comporte également une deuxième sortie 38 pour envoyer un signal d'avertissement, notamment à destination d'un utilisateur.

Par exemple, la deuxième sortie 38 inclut un connecteur ou un contact sec pour piloter un équipement distant tel qu'un relais, ou un témoin lumineux ou un avertisseur sonore directement raccordé à la deuxième sortie 38.

En variante, l'interface de communication peut incorporer un dispositif de communication capable d'envoyer un tel signal d'avertissement, tel qu'un témoin lumineux ou un avertisseur sonore, ou un dispositif électronique d'interface homme-machine comportant par exemple un écran d'affichage.

Selon d'autres variantes, la deuxième sortie 38 comporte une interface radiofréquence pour envoyer le signal d'avertissement au travers d'une liaison de communication radio, par exemple une liaison longue portée.

Selon des possibilités d'implémentation, comme illustré sur la figure 2, le module de surveillance 22 est séparé de l'appareil de protection 20, c'est-à-dire qu'il s'agit d'un élément dissociable et indépendant de l'appareil de protection 20. Le module de surveillance 22 est ici monté à l'extérieur de l'appareil de protection 20.

Selon d'autres possibilités d'implémentation, le module de surveillance 22 est intégré dans l'appareil de protection 20. Par exemple, le module de surveillance 22 peut être un élément distinct et indépendant de l'appareil de protection 20 tout en étant logé à l'intérieur d'un boîtier de l'appareil de protection 20.

En variante, le module de surveillance 22 est implémenté, par exemple sous forme logicielle, par une unité de commande électronique, telle qu'un déclencheur électronique, appartenant à l'appareil de protection 20.

Dans ce cas, le module de surveillance 22 ne possède pas nécessairement d'interface de communication ou d'entrées/sorties qui lui sont propres, mais peut à la place utiliser une interface de communication ou des entrées/sorties de l'unité de commande électronique de l'appareil de protection 20.

De façon générale, chacun des modules de surveillance 22 est programmé pour mettre en œuvre des d'étapes consistant à :
- mesurer une tension électrique et un courant électrique dans la liaison électrique 24 à laquelle est associée l'appareil de protection 20 auquel est associé le module de surveillance 22 ;
- calculer, à partir des valeurs de courant mesurées, une première moyenne mobile, dite moyenne courte, et une deuxième moyenne mobile, dite moyenne longue ;
- comparer la valeur de tension mesurée avec une valeur seuil de tension prédéfinie ;
- comparer la valeur courante de la première moyenne mobile avec la valeur courante de la deuxième moyenne mobile ;
- identifier une condition de déclenchement de l'appareil de protection 20 lorsque la valeur de tension mesurée est inférieure à la valeur seuil de tension prédéfinie pendant une durée supérieure à un seuil de durée prédéfini et que la valeur courante de la première moyenne mobile est supérieure ou égale à la valeur courante de la deuxième moyenne mobile.

Les étapes de mesure, de calcul et de comparaison sont par exemple réalisées de façon répétée au cours du temps, par exemple répétées périodiquement. Ainsi, on comprend que les première et deuxième moyennes mobiles sont construites à partir de plusieurs mesures de courant réalisées pour plusieurs instants au cours du temps.

Par exemple, des comparaisons du courant et de la tension peuvent être réalisées pour chaque phase ou pour plusieurs phases.

Selon un exemple, on compare d'une part la tension pour une phase avec ledit seuil et on compare d'autre part les moyennes mobiles calculées à partir du courant mesuré pour cette même phase.

Selon un autre exemple, on compare la tension composée entre deux phases avec ledit seuil et on compare les moyennes mobiles pour détecter une hausse du courant sur ces deux phases.

En pratique, la condition de déclenchement indique la présence d'un défaut électrique de type court-circuit ou défaut d'isolement.

Selon des modes de mise en œuvre, une fois la condition de déclenchement identifiée, une ou plusieurs actions peuvent être mises en œuvre par le module de surveillance 22 en vue de remédier à la cause d'apparition du défaut, parmi lesquelles l'envoi d'un signal de déclenchement, par exemple au moyen de la sortie 34, et/ou l'envoi d'un signal d'avertissement, par exemple au moyen de la sortie 38 ou de tout élément approprié de l'interface de communication.

Avantageusement, la présence d'une condition de déclenchement est enregistrée dans la mémoire de l'unité 30, par exemple sous la forme d'une première variable d'état.

Par exemple, la première variable d'état peut prendre une première valeur (état inactif) indiquant l'absence d'une condition de déclenchement ou une deuxième valeur (état actif) indiquant la présence d'une condition de déclenchement.

En pratique, la première moyenne mobile est calculée à partir d'un premier échantillon de valeurs de courant cumulées pendant une première durée. La deuxième moyenne mobile est calculée à partir d'un deuxième échantillon de valeurs de courants cumulées pendant une deuxième durée plus longue que la première durée. En d'autres termes, la deuxième moyenne mobile est calculée pour une durée plus longue que la première moyenne mobile.

De façon avantageuse, la première durée est inférieure ou égale à 1 seconde, ou inférieure ou égale à 500 millisecondes (ms), de préférence inférieure ou égale à 200ms, voire égale à 100ms. La deuxième durée est au moins cinq fois supérieure à la première durée, de préférence tout en étant par exemple inférieure ou égale à 10 secondes, ou inférieure ou égale à 5 secondes.

Selon des exemples, la première moyenne mobile est une moyenne mobile exponentielle. La deuxième moyenne mobile est une moyenne arithmétique.

En variante, les première et deuxième moyennes mobiles peuvent être choisies différemment.

L'utilisation des moyennes mobiles calculées à partir des valeurs de courant mesurées permet de détecter un défaut électrique avec un seuil de déclenchement qui s'adapte automatiquement en fonction des conditions de fonctionnement du réseau électrique 2.

Grâce à l'invention, la détection d'un défaut électrique est donc réalisée de façon plus fiable et d'une façon relativement simple à mettre en œuvre.

Selon des modes de mise en œuvre facultatifs, lorsqu'une condition de déclenchement est identifiée, le module de surveillance 22 attend pendant une durée prédéfinie (ici notée T4) puis mesure à nouveau une valeur de la tension électrique, la condition de déclenchement étant inhibée si la valeur mesurée de la tension électrique est redevenue supérieure à la valeur seuil de tension électrique.

Cette temporisation permet d'éviter de déclencher l'appareil de protection 20 si la tension électrique a retrouvé entre temps une amplitude nominale, ce qui réduit le risque de faux positifs.

Dans des modes de réalisation avantageux mais néanmoins optionnels, le module de surveillance 22 comporte une sortie 40 et/ou une entrée 42 destinés à être connectés à d'autres modules de surveillance 22, par exemple lorsque plusieurs appareils de protection 20 sont installés en cascade.

Cela permet notamment d'isoler le défaut électrique au bon niveau entre plusieurs appareils de coupure connectés en cascade au sein du réseau 2.

Par exemple, la sortie 40 délivre un signal noté Sel_out à un module de surveillance 22 associé à un appareil de protection 20 amont. L'entrée 42 reçoit un signal noté Sel_in provenant d'un ou de plusieurs modules de surveillance 22 associés à un ou plusieurs appareils de protection 20 installés en aval.

Dans l'exemple de la figure 1, les sorties 40 des modules de surveillance 22 du niveau Q3 sont raccordées à l'entrée 42 du module de surveillance 22 du niveau Q2 situé en amont.

Par exemple, lorsque plusieurs modules de surveillance 22 aval sont connectés en aval d'un module de surveillance 22, lesdits modules aval sont connectés en parallèle, de sorte que l'entrée 42 puisse recevoir un signal Sel_in lorsque un ou plusieurs des modules de surveillance 22 aval émet un signal correspondant.

De façon avantageuse mais néanmoins optionnelle, le module de surveillance 22 peut conserver en mémoire une information représentative de l'état du ou des modules de surveillance 22 aval connectés à l'entrée 42, par exemple sous la forme d'une deuxième variable d'état.

Par exemple, la deuxième variable d'état peut prendre un premier état correspondant à l'absence de signal Sel_in sur l'entrée 42, indiquant l'absence d'une condition de déclenchement dans les modules 22 aval, et un deuxième état correspondant à la présence d'un signal Sel_in reçu sur l'entrée 42, indiquant la présence d'une condition de déclenchement dans l'un des modules 22 aval.

Ainsi, selon des modes de mise en œuvre incluant une telle gestion de la sélectivité, le procédé peut en outre comporter :
- l'acquisition d'une information d'état émise par un deuxième module de surveillance 22 aval associé à un deuxième appareil de protection 20 connecté en aval dudit appareil de protection 20 ;
- l'inhibition de la condition de déclenchement pour ledit appareil de protection 20 si l'information d'état acquise indique qu'une condition de déclenchement a été identifiée par le deuxième module de surveillance 22 pour le deuxième appareil de protection 20.

Cela permet de ne pas déclencher un appareil de protection 20 situé en amont lorsque le défaut a déjà été détecté par un des appareils de protection 20 Aval. On évite ainsi de neutraliser l'alimentation électrique des branches du réseau 2 qui ne sont pas concernées par le défaut électrique.

Selon des exemples de mise en œuvre, lorsque la temporisation mettant en œuvre le délai d'attente T4 est utilisée dans plusieurs modules de surveillance 22 associés à des appareils de protection 20 montés en cascade, le délai d'attente est de préférence plus court pour les modules de surveillance situés en aval que pour les modules de surveillance situés en amont. Par exemple, pour les modules de surveillance 22 du niveau Q2, le délai T4 est égal à 300ms et, pour les modules de surveillance 22 du niveau Q3, le délai d'attente est égal à 200ms.

Cela permet notamment d'assurer une sélectivité dans le déclenchement des appareils de coupure connectés en cascade au sein du réseau 2, par exemple dans une même branche du réseau 2 partant de la liaison 24

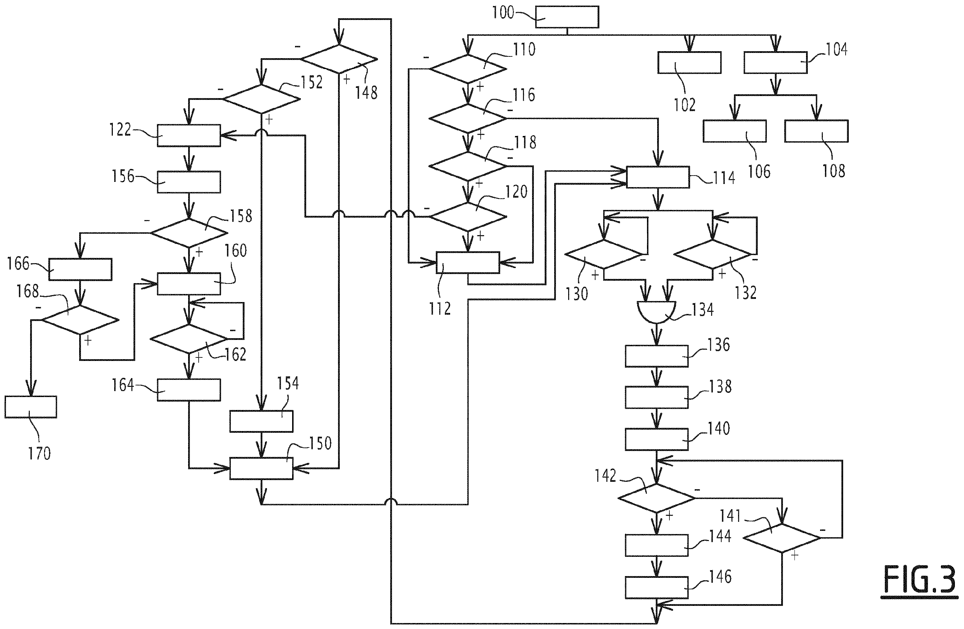

La figure 3 représente maintenant un exemple de fonctionnement du module de surveillance 22 selon un premier mode de réalisation.

Ce premier mode de réalisation peut notamment être avantageusement utilisé dans le cas où plusieurs modules de surveillance 22 sont associés à des appareils de protection 20 connectés en cascade, tels les appareils de protection des groupes Q2 et Q3 identifiés sur la figure 1, même si d'autres utilisations sont possibles.

A l'étape 100, le module de surveillance 22 est démarré.

Les mesures de tension électrique sont réalisées par les capteurs 32 lors d'une étape 102 répétée au cours du temps. En parallèle, les mesures de courant sont réalisées par les capteurs 32 lors d'une étape 104 elle aussi répétée au cours du temps.

Au fur et à mesure que les mesures de courant et de tension sont répétées, la première moyenne mobile est calculée lors d'une étape 106 et la deuxième moyenne mobile est calculée lors d'une étape 108.

Par exemple, le calcul est réalisé automatiquement par l'unité 30 et les valeurs courantes calculées des première et deuxième moyennes mobiles sont enregistrées dans la mémoire de l'unité 30.

Selon des modes de réalisation optionnels, en parallèle, l'unité de surveillance 22 met en œuvre, immédiatement après sa mise sous tension, une ou plusieurs étapes de diagnostic.

Par exemple, lors d'une étape 110, l'unité 22 détermine si l'appareil de protection 20 est dans un état ouvert et, si tel est le cas, alors la première variable d'état est réinitialisée vers la première valeur lors d'une étape 112.

Le cas échéant, lors d'une étape 114, la deuxième variable d'état est réinitialisée pour indiquer l'absence de condition de déclenchement dans les modules aval.

Dans le cas où l'appareil de protection 20 est identifié comme étant dans un état fermé, alors, lors d'une étape 116, le module 22 vérifie si la première variable d'état est dans le premier état.

Si ce n'est pas le cas, alors l'étape 114 est mise en œuvre.

Si la première variable d'état est égale à la première valeur, alors, pendant une étape 118, la tension mesurée est comparée à un premier seuil de tension prédéfini, ce seuil étant par exemple égale à 70% de la tension électrique nominale pendant un temps minimum réglable, par exemple au moins 50ms.

Si la tension mesurée est supérieure au premier seuil, alors l'étape 112 est mise en œuvre.

Si la tension mesurée est inférieure au premier seuil, alors une étape 120 est mise en œuvre, dans laquelle le module 22 vérifie si la deuxième variable d'état est dans le deuxième état. Si tel est le cas, le procédé passe à l'étape 112.

Dans le cas contraire, c'est-à-dire si la deuxième variable d'état est égale à la deuxième valeur indiquant une absence de condition de déclenchement en aval, alors une condition de déclenchement est identifiée.

En conséquence, dans cet exemple, lors d'une étape 122, un signal de déclenchement est envoyé par le module 22 pour commuter l'appareil de protection 20 vers l'état ouvert.

En variante, l'étape 118 peut être omise, le procédé passant directement à l'étape 120.

Dans ce premier mode de réalisation, suite à l'étape 114, lors d'une étape 130 répétée au cours du temps, la valeur mesurée de tension est comparée avec un seuil de tension prédéfini pour déterminer si la valeur de tension mesurée est inférieure à la valeur seuil de tension prédéfinie pendant une première durée T1 supérieure à un seuil de durée prédéfini.

Par exemple, ce seuil de tension est le même que le premier seuil prédéfini décrit ci-dessus. La première durée est ici supérieure ou égale à une durée réglable, par exemple choisie égale à 50ms.

En parallèle, lors d'une étape 132 répétée au cours du temps, les valeurs courantes respectives des première et deuxième moyennes mobiles sont comparées entre elles pour déterminer si la valeur courante de la première moyenne mobile (courte) devient supérieure (avec optionnellement une marge prédéfinie) à la valeur courante de la deuxième moyenne mobile (longue).

Si le résultat des deux comparaisons menées lors de l'étape 130 et de l'étape 132 est positif, alors une condition de déclenchement est identifiée lors de l'étape 134.

Dans le cas contraire, les étapes 102, 104, 106, 108, 130 et 132 continuent d'être répétées jusqu'à la fin du procédé.

Avantageusement, lors d'une étape 136, la présence du défaut est enregistrée en mémoire. Par exemple, la première variable d'état devient égale à la deuxième valeur.

Puis, lors d'une étape 138, le module 22 émet un signal d'état indiquant la présence de la condition de déclenchement. Par exemple, le signal Sel_out est émis sur la sortie 40 à destination, le cas échéant, du ou des modules de surveillance 22 connectés en amont.

De préférence, lors d'une étape 140, le module 22 démarre le décomptage de la durée prédéfinie T4, par exemple au moyen d'une horloge implémentée par le circuit 30.

Lors d'une étape 142, le module de surveillance 22 vérifie l'état de l'entrée 42 notamment pour détecter une information d'état émise par un module de surveillance 22 aval indiquant qu'un appareil de protection 20 connecté en aval est dans une condition de déclenchement. Par exemple, lors de l'étape 142, le module 22 détecte que le signal Sel_in est reçu sur l'entrée 42 avec une valeur haute.

Dans ce cas, lors d'une étape 144, la deuxième variable d'état est changée à la deuxième valeur pour indiquer la présence d'une condition de déclenchement en aval de l'appareil de protection 20. Puis, lors d'une étape 146, la première variable d'état est réinitialisée à sa première valeur, puisque le défaut électrique a déjà été détecté par un appareil de protection situé en aval.

Dans le cas où aucune information d'état n'est reçue à l'issue de l'étape 142, alors une étape 141 est mise en œuvre pour vérifier si la temporisation T4 est écoulée, c'est-à-dire si le décompte de la durée T4 initié lors de l'étape 140 est terminé. Si ce n'est pas le cas, l'étape 142 est à nouveau mise en œuvre.

A l'expiration de la durée prédéfinie T4, lors d'une étape 148, le module 22 vérifie automatiquement si la tension électrique mesurée est toujours inférieure (ou égale) à la valeur seuil de tension électrique.

Si non, c'est-à-dire si la valeur mesurée de la tension électrique est redevenue supérieure à la valeur seuil de tension électrique, alors la condition de déclenchement est inhibée et, lors d'une étape 150, le module 22 cesse d'émettre un signal d'état indiquant la présence de la condition de déclenchement. Le procédé repart à l'étape 114.

Si oui, c'est-à-dire si la valeur mesurée de la tension électrique est restée inférieure (ou égale) à la valeur seuil de tension électrique, lors d'une étape 152, le module 22 vérifie si la deuxième variable d'état est égale à la deuxième valeur. En d'autres termes, le module 22 vérifie si la deuxième variable d'état indique la présence d'une condition de déclenchement en aval.

Si tel est le cas, alors la condition de déclenchement est là aussi inhibée, puisque même si la tension n'est pas revenue à un niveau normal, la détection d'un défaut a déjà été réalisée par un module situé en aval. Une étape 154 est alors mise en œuvre, dans laquelle un délai d'attente T5 est décompté. Puis le procédé passe à l'étape 150 précédemment décrite. Par exemple, le délai d'attente T5 est égal à 50ms.

Cette temporisation permet de laisser suffisamment de temps au module de surveillance aval pour déclencher l'appareil de protection aval correspondant.

L'indication de la présence du défaut est néanmoins gardée en mémoire pendant ce temps au cas où l'alimentation électrique du réseau 2 serait interrompue avant que l'appareil de protection 20 n'ait eu le temps d'être ouvert.

De façon générale, l'utilisation de la première variable d'état et/ou de la deuxième variable d'état, bien qu'optionnel, est néanmoins avantageuse car elle permet de garder en mémoire les informations relatives à la détection d'un défaut par le module 22 ou par un module aval même lorsque l'alimentation électrique du réseau 2 est interrompue prématurément à cause notamment d'une défaillance de l'onduleur 16.

Si une telle interruption se produit, le module 22 peut malgré tout traiter le défaut électrique dès son redémarrage une fois que l'alimentation électrique est rétablie, grâce aux informations stockées dans la mémoire non-volatile du circuit 30 et notamment grâce aux étapes de diagnostic 116, 118 et 120 décrites ci-dessus.

A l'issue de l'étape 152, si le module 22 n'a déterminé aucune condition de déclenchement en aval, alors lors d'une étape 122 déjà décrite précédemment, un signal de déclenchement est envoyé pour commuter l'appareil 20 vers l'état ouvert.

Avantageusement, lors d'une étape 156, un signal d'avertissement est également émis, par exemple à l'aide de l'interface de communication précédemment décrite.

A l'étape 158, le module 22 vérifie si l'appareil de protection 20 est dans l'état ouvert. Si oui, lors d'une étape 160, la première variable d'état est réinitialisée vers la première valeur indiquant l'absence de défaut. En effet, à ce stade, il n'est plus nécessaire de conserver en mémoire, puisqu'une action correctrice a été prise au travers des étapes 156 et 158.

Optionnellement, à l'étape 162, le module 22 vérifie si l'appareil de protection 20 a été refermé, par exemple suite à une opération manuelle de réarmement et refermeture menée par un opérateur. Tant que l'appareil de protection 20 n'a pas été refermé, l'étape 162 est répétée.

Une fois que l'appareil de protection 20 est détecté comme ayant été refermé, alors, lors d'une étape 164, le module 22 réinitialise le signal d'avertissement. Par exemple, le signal lumineux est éteint, ou le signal sonore cesse d'être émis, ou des trames radio cessent d'être envoyées. Le procédé passe alors à l'étape 150 précédemment décrite.

Optionnellement, à l'issue de l'étape 158, si le module 22 détecte que l'appareil de protection 20 ne s'est pas ouvert, alors le module 22 envoie à nouveau un signal de commande (étape 166) puis vérifie à nouveau si l'appareil de protection 20 est dans l'état ouvert (étape 168). Si oui, le procédé passe à l'étape 160. Si non, le module 22 envoie un signal d'erreur (étape 170), par exemple à l'aide de l'interface de communication, pour indiquer une défaillance de l'appareil de protection 20.

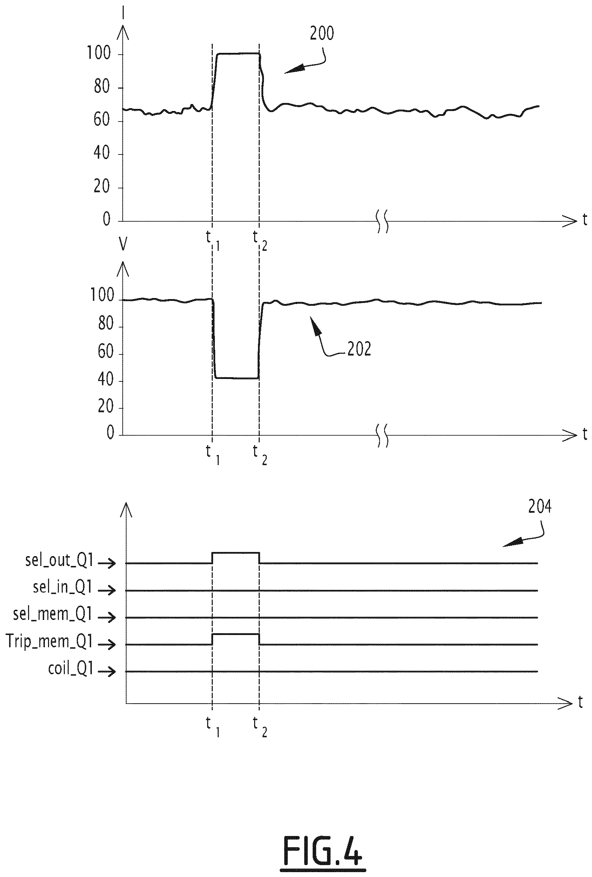

La figure 4 représente un chronogramme illustrant un autre exemple de fonctionnement du procédé décrit ci-dessus, mis en œuvre pour le module de surveillance 22 et l'appareil de protection 20 de la branche Q1 du réseau 2.

Les courbes 200 et 202 représentent respectivement l'évolution de l'amplitude du courant I (exprimés en ampères) et de la tension V (exprimée en pourcentage relativement à la valeur nominale), en fonction du temps t (unités arbitraires) pour la liaison électrique sur laquelle est monté l'appareil de protection 20.

Dans l'exemple illustré, un défaut électrique survient à un instant t₁ et disparaît à un instant ultérieur t₂. Le courant I reste relativement constant au cours du temps sauf entre les instants t₁ et t2 où son amplitude augmente fortement. En parallèle, l'amplitude moyenne de la tension V reste relativement constante, sauf qu'elle diminue entre les instants t₁ et t2. Ainsi, une condition de déclenchement est identifiée par le module 22 à l'instant t₁.

Le graphe 204 représente l'évolution de l'état de mémoires et de signaux d'état au sein du module 22 au cours du temps t. Ils sont ici illustrés comme pouvant prendre une valeur basse (indiquant un état inactif) et une valeur haute (indiquant un état actif), bien qu'en pratique d'autres implémentations sont possibles.

Dans cet exemple, le décompte de la durée T4 commence ici à l'instant t₁. La disparition du défaut à l'instant t₂ survient avant l'expiration du délai T4.

Le signal « Sel_out_Q1 » indiquant l'information d'état délivrée sur la sortie 40 est ici activé à l'instant t₁, et se termine à l'instant t₂. La première variable d'état « Trip_mem_Q1 » passe à l'état actif à l'instant t₁ et repasse à l'état inactif à l'instant t2.

Comme le module de surveillance 22 n'est connecté à aucun module aval dans la branche Q1, le signal « sel_in_Q1 » indiquant l'état de l'entrée 40 et la deuxième variable d'état « sel_mem_Q1 » restent inactifs.

En pratique, l'étape 142 est mise en œuvre en continu dès le début du décompte et sans forcément attendre la fin du délai T4 à la fin de l'étape 140.

Puisque la tension électrique a retrouvé une valeur normale avant l'expiration du délai T4, alors l'appareil de protection 20 n'est pas déclenché. Le signal de commande « coil_Q1 » reste donc inactif.

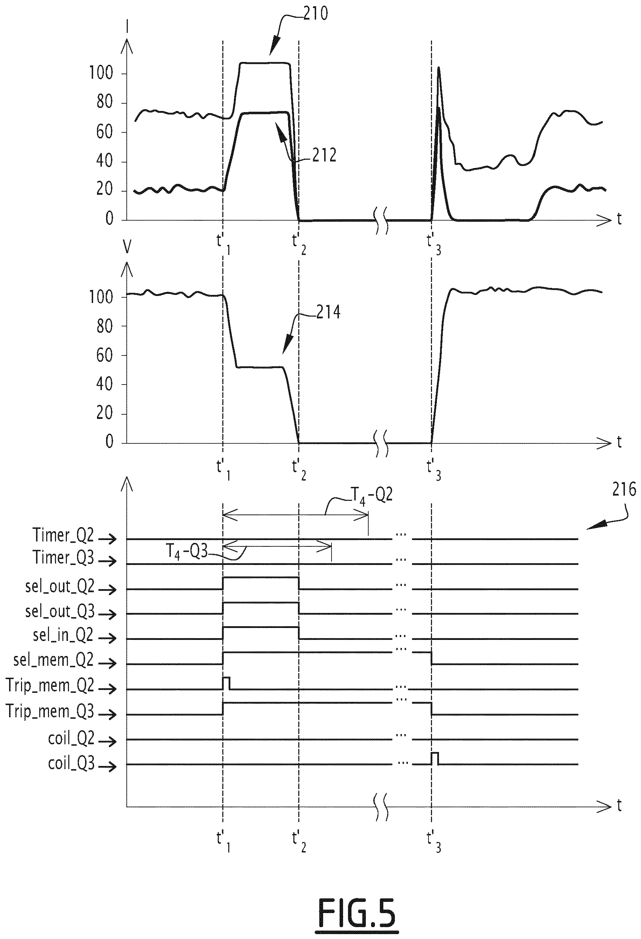

La figure 5 représente un chronogramme illustrant un autre exemple du fonctionnement du procédé décrit ci-dessus, mis en œuvre par les modules de surveillance 22 des appareils de protection 20-3 et 20-4 du réseau 2.

Les courbes 210 et 212 représentent l'évolution de l'amplitude du courant I, exprimée en ampère, en fonction du temps t (unités arbitraires) respectivement pour l'appareil de protection Q2 et pour un des appareils de protection 20-3 du deuxième niveau. La courbe 214 représente l'évolution de la tension V, exprimée en pourcentage relativement à la valeur nominale, en fonction du temps t.

Dans l'exemple illustré, un défaut électrique survient à un instant t'₁ au niveau Q3, en aval de l'appareil de protection Q2. L'alimentation électrique du réseau 2 est interrompue à l'instant ultérieur t'₂ du fait d'une défaillance de l'onduleur 16. A l'instant t'3 l'onduleur est réarmé par un opérateur.

Ainsi, les amplitudes des courants augmentent à partir de l'instant t'₁ et chutent à zéro après l'instant t'₂ avant de remonter brusquement à partir de l'instant t'₃. L'amplitude de la tension V diminue de moitié à l'instant t'₁ puis reste stable avant de chuter à zéro à l'instant t'₂ puis de remonter brutalement à l'instant t'₃.

Le graphe 216 représente l'évolution de l'état de mémoires et de signaux d'état au sein du module 22 au cours du temps t. Ils sont ici illustrés comme pouvant prendre une valeur basse (indiquant un état inactif) et une valeur haute (indiquant un état actif), bien qu'en pratique d'autres implémentations sont possibles.

Dans cet exemple, le symbole Q2 ou Q3 dans le nom du signal indique que ce signal se rapporte, respectivement, au module de surveillance 22 placé en amont (appareil Q2) ou en aval (appareil Q3).

Les lignes « Timer_Q2 » et « Timer_Q3 » indiquent le début et la fin du décompte mis en œuvre lors de l'étape 140. Le décompte commence ici à l'instant t'₁ et se termine à des instants différents pour les deux modules, puisque la durée T4 (notée T4-Q3) du module 22 aval est préférentiellement choisie plus courte que la durée T4 (notée T4-Q2) du module 22 amont. Dans cet exemple, l'instant t'₃ est de toute façon postérieur à l'expiration des deux délais T4.

Les signaux « Sel_out_Q2 » et « Sel_out_Q3 » indiquant l'information d'état délivrée sur la sortie 40 du module 22 correspondant sont tous les deux activés à l'instant t'₁, et sont inactivés à l'instant t'₂ suite à l'interruption de l'alimentation. Le signal « Sel_in_Q2 » correspond au signal « Sel_out_Q3 » émis par le module 22 aval et reçu sur l'entrée 40 du module 22 amont.

La deuxième variable d'état « sel_mem_Q2 » du module aval est activée à brève échéance après l'instant t'₁ suite à l'étape 146. Grâce à l'enregistrement dans la mémoire non-volatile, la deuxième variable d'état est maintenue même pendant l'interruption de l'alimentation électrique.

De façon analogue, les premières variables d'état « Trip_mem_Q2 » et « Trip_mem_Q3 » passent à l'état actif à brève échéance après l'instant t'₁ et sont conservées en mémoire même pendant l'interruption de l'alimentation électrique. « Trip_mem_Q2 » est rapidement réinitialisée puisque la variable d'état « sel_mem_Q2 » est dans l'état activé.

En effet, en pratique, le signal d'entrée « sel_in » de l'appareil de protection peut être activé à tout moment pendant le décompte de la durée T4 et ainsi réinitialiser la variable « sel_mem » correspondante.

Lors de la reprise de l'alimentation électrique, les modules 22 redémarrent à l'instant t'₃ et lisent les valeurs des première et deuxième variables d'état enregistrées en mémoire, par exemple lors des étapes 116 et 120.

A brève échéance après l'instant t'₃, puisque le défaut est présent seulement en aval, le module 22 aval active le signal de commande « coil_Q3 » pour déclencher et ouvrir l'appareil de protection aval 20 correspondant.

En revanche, grâce à la sélectivité, la condition de déclenchement est inhibée dans le module 22 amont et le signal de commande « coil_Q2 » reste inactif.

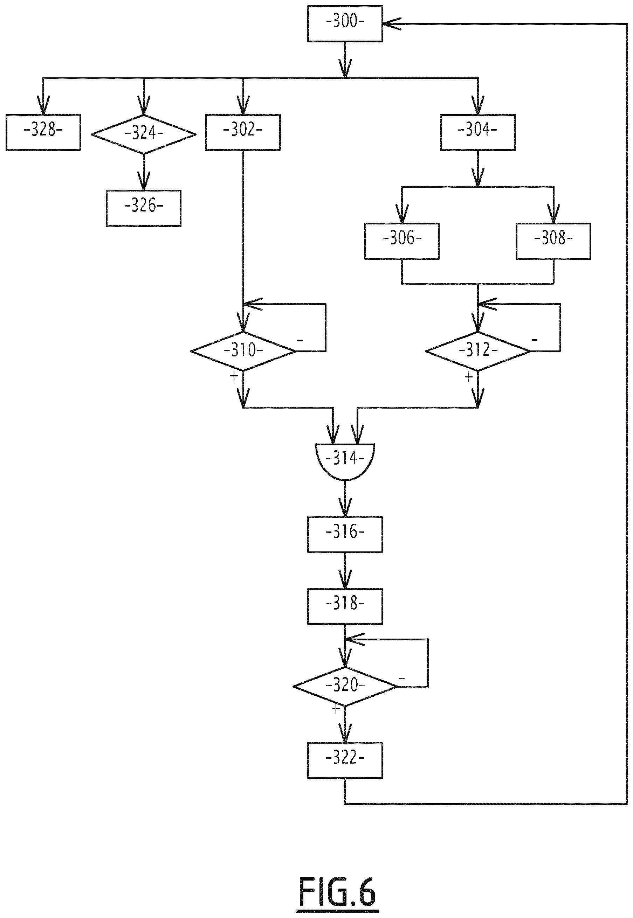

La figure 6 représente un deuxième mode de réalisation de l'invention. Les éléments de ce mode de réalisation qui sont analogues au premier mode de réalisation portent les mêmes références et ne sont pas décrits en détail, dans la mesure où la description ci-dessus peut leur être transposée.

Par exemple, ce deuxième mode de réalisation peut avantageusement être mise en œuvre dans des réseaux utilisant des appareils de protection 20 installations à bas coût et/ou présentant une conception simplifiée, notamment pour des applications destinées à des marchés de pays émergents et/ou pour équiper des réseaux déjà existants (« retrofitting » en anglais).

En particulier, ce deuxième mode de réalisation diffère du premier mode de réalisation en ce que, lorsqu'une condition de déclenchement est identifiée, le module de surveillance ne déclenche pas l'appareil de protection, mais se contente d'afficher un avertissement, ce qui permet néanmoins de localiser l'origine du défaut électrique dans le réseau et d'agir en conséquence. Par ailleurs, les étapes correspondant à la gestion de la sélectivité et la mémorisation des première et deuxième variables d'état.

Ce mode de réalisation comporte notamment des étapes 300 à 314 respectivement similaires aux étapes 108 à 110 et 130 à 134 précédemment décrites.

Ainsi, le module de surveillance 22, après son démarrage (étape 300) mesure une tension électrique (étape 302) et un courant électrique (étape 304) puis calcule la première moyenne mobile (étape 306) et la deuxième moyenne mobile (étape 308). La valeur de tension mesurée est comparée avec une la valeur seuil de tension prédéfinie (étape 310) et la valeur courante de la première moyenne mobile est comparée avec la valeur courante de la deuxième moyenne mobile (étape 312) afin d'identifier une condition de déclenchement de l'appareil de protection 20 correspondant (étape 314).

En particulier, une condition de déclenchement de l'appareil de protection est identifiée lorsque la valeur de tension mesurée est inférieure à la valeur seuil de tension prédéfinie pendant une durée supérieure à un seuil de durée prédéfini et que la valeur courante de la première moyenne mobile est supérieure à la valeur courante de la deuxième moyenne mobile.

En parallèle si un défaut a été mémorisé précédemment, ce qui est vérifié lors d'une étape 324, alors le module émet automatiquement un signal d'avertissement (étape 326), par exemple de façon analogue à l'étape 156.

Le signal d'avertissement peut à tout moment être réinitialisé manuellement par un opérateur, comme illustré par l'étape 328. Dans cet exemple, la mise en œuvre du procédé est relativement simplifiée et aucun contrôle automatique n'est effectué sur les actions de réinitialisation du signal d'avertissement par l'opérateur.

Une fois la condition de déclenchement identifiée, le module émet un signal d'avertissement et le mémorise lors d'une étape 316 similaire à l'étape 156, puis attend pendant la durée prédéfinie T4 lors d'une étape 318 similaire à l'étape 140.

A l'issue du décompte, lors d'une étape 320 similaire à l'étape 148, le module de surveillance 22 vérifie automatiquement si la tension électrique mesurée est toujours inférieure (ou égale) à la valeur seuil de tension électrique.

Si non, c'est-à-dire si la valeur mesurée de la tension électrique est redevenue supérieure à la valeur seuil de tension électrique, alors lors d'une étape 322 similaire à l'étape 164, le module 22 cesse d'émettre le signal d'avertissement et la mémoire de cette alarme est réinitialisée.

Dans le cas contraire, l'étape 320 est répétée jusqu'à expiration du délai T4.

Les modes de réalisation et les variantes envisagés ci-dessus peuvent être combinés entre eux pour donner naissance à de nouveaux modes de réalisation, dans les limites définies par les revendications ci-annexées.

## Revendications

1. Procédé comportant la mise en œuvre, par un module électronique de surveillance (22) associé à un appareil de protection électrique (20), d'étapes consistant à :
- mesurer (102, 104 ; 302, 304), de façon répétée, une tension électrique et un courant électrique dans une liaison électrique (24) à laquelle est associée ledit appareil de protection électrique ;
**caractérisé en ce que** le procédé comporte en outre des étapes consistant à :
- calculer (106, 108 ; 306, 308), de façon répétée, à partir des valeurs de courant mesurées, une première moyenne mobile et une deuxième moyenne mobile, la deuxième moyenne mobile étant calculée pour une durée plus longue que la première moyenne mobile ;
- comparer (120 ; 310) la valeur de tension mesurée avec une valeur seuil de tension prédéfinie ;
- comparer (132 ; 312) la valeur courante de la première moyenne mobile avec la valeur courante de la deuxième moyenne mobile ;
- identifier (134 ; 314) une condition de déclenchement de l'appareil de protection lorsque la valeur de tension mesurée est inférieure à la valeur seuil de tension prédéfinie pendant une durée supérieure à un seuil de durée prédéfini et que la valeur courante de la première moyenne mobile est supérieure à la valeur courante de la deuxième moyenne mobile.

2. Procédé selon la revendication 1, **caractérisé en ce qu'**il comporte en outre l'émission (156 ; 316), par le module électronique de surveillance (22), d'un signal d'avertissement lorsqu'une condition de déclenchement est identifiée.

3. Procédé selon la revendication 1 ou la revendication 2, **caractérisé en ce qu'**il comporte l'émission (122), par le module électronique de surveillance (22), d'un signal de déclenchement à destination de l'appareil de protection (20) lorsqu'une condition de déclenchement est identifiée.

4. Procédé selon l'une quelconque des revendications précédentes, **caractérisé en ce qu'**il comporte en outre, lorsqu'une condition de déclenchement est identifiée, l'enregistrement en mémoire (136), par le module électronique de surveillance (22), d'une variable d'état indiquant la présence d'une condition de déclenchement et **en ce que**, du démarrage du module électronique de surveillance (22), une condition de déclenchement est identifiée si la variable d'état enregistrée en mémoire indique la présence d'une condition de déclenchement.

5. Procédé selon l'une quelconque des revendications précédentes, **caractérisé en ce que**, lorsqu'une condition de déclenchement est identifiée, le procédé comporte en outre des étapes consistant à attendre pendant une durée prédéfinie (T4) puis mesurer à nouveau une valeur de la tension électrique, la condition de déclenchement étant inhibée si la valeur mesurée de la tension électrique est inférieure à la valeur seuil de tension électrique.

6. Procédé selon l'une quelconque des revendications précédentes, **caractérisé en ce qu'**il comporte en outre :
- l'acquisition d'une information d'état émise par un deuxième module électronique de surveillance (22, Q3) semblable audit module électronique de surveillance (22, Q2), ce deuxième module électronique de surveillance (22, Q3) étant associé à un deuxième appareil de protection (20, Q3) connecté en aval dudit appareil de protection (20, Q2) sur la même liaison électrique (24) ;
- l'inhibition de la condition de déclenchement pour ledit appareil de protection (20, Q2) si l'information d'état acquise indique qu'une condition de déclenchement a été identifiée par le deuxième module électronique de surveillance (22, Q3) pour le deuxième appareil de protection (20, Q3).

7. Procédé selon l'une quelconque des revendications précédentes, **caractérisé en ce que** la première moyenne mobile est calculée pour une première durée inférieure ou égale à 1 seconde, de préférence inférieure ou égale à 500ms et **en ce que** la deuxième moyenne mobile est calculée pour une deuxième durée supérieure à la première durée, de préférence au moins cinq fois supérieure à la première durée, la deuxième durée étant par exemple inférieure ou égale à 10 secondes, ou inférieure ou égale à 5 secondes.

8. Système (28) comportant un appareil de protection électrique (20) et un module électronique de surveillance (22) associé à l'appareil de protection électrique, le module électronique de surveillance (22) est programmé pour :
- mesurer (102, 104 ; 302, 304), de façon répétée, une tension électrique et un courant électrique dans une liaison électrique (24) à laquelle est associée ledit appareil de protection électrique ;
**caractérisé en ce que** le module électronique de surveillance (22) est en outre programmé pour :
- calculer (106, 108 ; 306, 308), de façon répétée, à partir des valeurs de courant mesurées, une première moyenne mobile et une deuxième moyenne mobile, la deuxième moyenne mobile étant calculée pour une durée plus longue que la première moyenne mobile ;
- comparer (120 ; 310) la valeur de tension mesurée avec une valeur seuil de tension prédéfinie ;
- comparer (132 ; 312) la valeur courante de la première moyenne mobile avec la valeur courante de la deuxième moyenne mobile ;
- identifier (134 ; 314) une condition de déclenchement de l'appareil de protection lorsque la valeur de tension mesurée est inférieure à la valeur seuil de tension prédéfinie pendant une durée supérieure à un seuil de durée prédéfini et que la valeur courante de la première moyenne mobile est supérieure à la valeur courante de la deuxième moyenne mobile.

9. Système selon la revendication 8, **caractérisé en ce que** le module électronique de supervision (22) est intégré à l'appareil de protection (20), par exemple implémenté par un déclencheur électronique de l'appareil de protection (20).

10. Système selon la revendication 8, **caractérisé en ce que** le module électronique de supervision (22) est séparé de l'appareil de protection (20) et monté à l'extérieur de l'appareil de protection (20).

11. Réseau de distribution électrique (2), notamment un micro-réseau, comportant :
- un dispositif de stockage d'électricité (STOR) et/ou un dispositif de génération d'électricité (SOL), alimentant une liaison principale (4) ;
- au moins une charge électrique, connectée à la liaison principale par l'intermédiaire d'un système de protection selon la revendication 10.

## Patentansprüche

1. Verfahren, umfassend das Implementieren, durch ein elektronisches Überwachungsmodul (22), das mit einem elektrischen Schutzgerät (20) assoziiert ist, von Schritten, die aus Folgendem bestehen:
- wiederholtes Messen (102, 104; 302, 304) einer elektrischen Spannung und eines elektrischen Stroms in einer elektrischen Verbindung (24), mit der das elektrische Schutzgerät assoziiert ist;
**dadurch gekennzeichnet, dass** das Verfahren ferner Schritte umfasst, die aus Folgendem bestehen:
- wiederholtes Berechnen (106, 108; 306, 308), anhand der gemessenen Stromwerte, eines ersten gleitenden Mittelwerts und eines zweiten gleitenden Mittelwerts, wobei der zweite gleitende Mittelwert über eine längere Zeitdauer als der erste gleitende Mittelwert berechnet wird;
- Vergleichen (120; 310) des gemessenen Spannungswerts mit einem vordefinierten Spannungsschwellenwert;
- Vergleichen (132; 312) des aktuellen Werts des ersten gleitenden Mittelwerts mit dem aktuellen Wert des zweiten gleitenden Mittelwerts;
- Identifizieren (134; 314) einer Auslösebedingung des Schutzgeräts, wenn der gemessene Spannungswert über eine Zeitdauer, die größer ist als ein vordefinierter Zeitdauerschwellenwert, unter dem vordefinierten Spannungsschwellenwert ist und der aktuelle Wert des ersten gleitenden Mittelwerts größer ist als der aktuelle Wert des zweiten gleitenden Mittelwerts.

2. Verfahren nach Anspruch 1, **dadurch gekennzeichnet, dass** es ferner das Aussenden (156; 316), durch das elektronische Überwachungsmodul (22), eines Warnsignals umfasst, wenn eine Auslösebedingung identifiziert wird.

3. Verfahren nach Anspruch 1 oder 2, **dadurch gekennzeichnet, dass** es das Senden (122), durch das elektronische Überwachungsmodul (22), eines Auslösesignals an das Schutzgerät (20) umfasst, wenn eine Auslösebedingung identifiziert wird.

4. Verfahren nach einem der vorherigen Ansprüche, **dadurch gekennzeichnet, dass** es ferner umfasst, dass, wenn eine Auslösebedingung identifiziert wird, das elektronische Überwachungsmodul (22) in dem Speicher (136) eine Zustandsvariable registriert, die das Vorhandensein einer Auslösebedingung angibt, und dass beim Starten des elektronischen Überwachungsmoduls (22) eine Auslösebedingung identifiziert wird, wenn die in dem Speicher registrierte Zustandsvariable das Vorhandensein einer Auslösebedingung angibt.

5. Verfahren nach einem der vorherigen Ansprüche, **dadurch gekennzeichnet, dass**, wenn eine Auslösebedingung identifiziert wird, das Verfahren ferner die Schritte umfasst, die darin bestehen, über eine vordefinierte Zeitdauer (T4) zu warten und dann erneut einen Wert der elektrischen Spannung zu messen, wobei die Auslösebedingung gehemmt wird, wenn der gemessene Wert der elektrischen Spannung niedriger ist als der Schwellwert der elektrischen Spannung.

6. Verfahren nach einem der vorherigen Ansprüche, **dadurch gekennzeichnet, dass** sie ferner Folgendes umfasst:
- Erfassen von Zustandsinformationen, die von einem zweiten elektronischen Überwachungsmodul (22, Q3) ausgegeben werden, das dem elektronischen Überwachungsmodul (22, Q2) ähnlich ist, wobei dieses zweite elektronische Überwachungsmodul (22, Q3) mit einem zweiten Schutzgerät (20, Q3) assoziiert ist, das stromabwärts von dem Schutzgerät (20, Q2) über die gleiche elektrische Verbindung (24) verbunden ist;
- die Hemmung der Auslösebedingung für das Schutzgerät (20, Q2), wenn die erfasste Zustandsinformationen angibt, dass durch das zweite elektronische Überwachungsmodul (22, Q3) eine Auslösebedingung für das zweite Schutzgerät (20, Q3) identifiziert wird.

7. Verfahren nach einem der vorherigen Ansprüche, **dadurch gekennzeichnet, dass** der erste gleitende Durchschnitt über eine erste Dauer berechnet wird, die kleiner als oder gleich wie 1 Sekunde ist, vorzugsweise kleiner als oder gleich wie 500 ms, und dass der zweite gleitende Durchschnitt über eine zweite Dauer berechnet wird, die größer ist als die erste Dauer, vorzugsweise mindestens fünfmal größer als die erste Dauer, wobei die zweite Dauer beispielsweise kleiner als oder gleich wie 10 Sekunden oder kleiner als oder gleich wie 5 Sekunden ist.

8. System (28), umfassend ein elektrisches Schutzgerät (20) und ein elektronisches Überwachungsmodul (22), das mit dem elektrischen Schutzgerät assoziiert ist, wobei das elektronische Überwachungsmodul (22) zu Folgendem programmiert ist:
- wiederholtes Messen (102, 104; 302, 304) einer elektrischen Spannung und eines elektrischen Stroms in einer elektrischen Verbindung (24), mit der das elektrische Schutzgerät assoziiert ist;
**dadurch gekennzeichnet, dass** das elektronische Überwachungsmodul (22) ferner zu Folgendem programmiert ist:
- wiederholtes Berechnen (106,108; 306,308), anhand der gemessenen Stromwerte, eines ersten gleitenden Mittelwerts und eines zweiten gleitenden Mittelwerts, wobei der zweite gleitende Mittelwert über eine längere Zeitdauer als der erste gleitende Mittelwert berechnet wird;
- Vergleichen (120; 310) des gemessenen Spannungswerts mit einem vordefinierten Spannungsschwellenwert;
- Vergleichen (132; 312) des aktuellen Werts des ersten gleitenden Mittelwerts mit dem aktuellen Wert des zweiten gleitenden Mittelwerts;
- Identifizieren (134; 314) einer Auslösebedingung des Schutzgeräts, wenn der gemessene Spannungswert über eine Zeitdauer, die größer ist als ein vordefinierter Zeitdauerschwellenwert, unter dem vordefinierten Spannungsschwellenwert ist und der aktuelle Wert des ersten gleitenden Mittelwerts größer ist als der aktuelle Wert des zweiten gleitenden Mittelwerts.

9. System nach Anspruch 8, **dadurch gekennzeichnet, dass** das elektronische Überwachungsmodul (22) in das Schutzgerät (20) integriert ist, z. B. implementiert durch einen elektronischen Auslöser des Schutzgeräts (20).

10. System nach Anspruch 8, **dadurch gekennzeichnet, dass** das elektronische Überwachungsmodul (22) von dem Schutzgerät (20) getrennt und außerhalb des Schutzgeräts (20) montiert ist.

11. Elektrisches Verteilungsnetzwerk (2), insbesondere ein Mikronetzwerk, umfassend:
- eine Stromspeichervorrichtung (STOR) und/oder eine Stromerzeugungsvorrichtung (SOL), die eine Hauptverbindung (4) mit Strom versorgt;
- mindestens eine elektrische Last, die über ein Schutzsystem nach Anspruch 10 mit der Hauptverbindung verbunden ist.

## Claims

1. A method comprising the implementation, by an electronic monitoring module (22) associated with an electrical protection device (20), of steps consisting of:
- repeatedly measuring (102, 104; 302, 304) an electrical voltage and an electrical current in an electrical link (24) with which said electrical protection device is associated;
**characterised in that** the method further comprises the steps consisting of:
- repeatedly calculating (106, 108; 306, 308) from the measured current values a first moving average and a second moving average, the second moving average being calculated for a longer period of time than the first moving average;
- comparing (120; 310) the measured voltage value with a predefined voltage threshold value;
- comparing (132; 312) the current value of the first moving average with the current value of the second moving average;
- identifying (134; 314) a condition for triggering the protection device when the measured voltage value is below the predefined voltage threshold value for a period of time greater than a predefined time threshold and the current value of the first moving average is greater than the current value of the second moving average.

2. The method according to claim 1, **characterised in that** it further comprises the electronic monitoring module (22) transmitting (156; 316) a warning signal when a trigger condition is identified.

3. The method according to claim 1 or claim 2, **characterised in that** it comprises the transmission (122), by the electronic monitoring module (22), of a trigger signal to the protection device (20) when a trigger condition is identified.

4. The method according to any one of the preceding claims, **characterised in that** it further comprises, when a trigger condition is identified, the electronic monitoring module (22) recording in the memory (136) a status variable indicating the presence of a trigger condition and **in that**, upon start-up of the electronic monitoring module (22), a trigger condition is identified if the status variable recorded in the memory indicates the presence of a trigger condition.

5. The method according to any one of the preceding claims, **characterised in that**, when a trigger condition is identified, the method further comprises steps of waiting for a predefined period of time (T4) and then re-measuring a value of the electrical voltage, the trigger condition being inhibited if the measured value of the electrical voltage is below the electrical voltage threshold value.

6. The method according to any one of the preceding claims, **characterised in that** it further comprises:
- acquiring status information emitted by a second electronic monitoring module (22, Q3) similar to said electronic monitoring module (22, Q2), this second electronic monitoring module (22, Q3) being associated with a second protection device (20, Q3) connected downstream of said protection device (20, Q2) on the same electrical link (24);
- inhibiting the trigger condition for said protective device (20, Q2) if the acquired status information indicates that a trigger condition has been identified by the second electronic monitoring module (22, Q3) for the second protective device (20, Q3).

7. The method according to any of the preceding claims, **characterised in that** the first moving average is calculated for a first duration less than or equal to 1 second, preferably less than or equal to 500 ms, and **in that** the second moving average is calculated for a second duration greater than the first duration, preferably at least five times greater than the first duration, the second duration being for example less than or equal to 10 seconds, or less than or equal to 5 seconds.

8. A system (28) comprising an electrical protection device (20) and an electronic monitoring module (22) associated with the electrical protection device, wherein the electronic monitoring module (22) is programmed for:
- repeatedly measuring (102, 104; 302, 304) an electrical voltage and an electrical current in an electrical link (24) with which said electrical protection device is associated;
**characterised in that** the electronic monitoring module (22) is further programmed to:
- repeatedly calculate (106, 108; 306, 308) from the measured current values a first moving average and a second moving average, the second moving average being calculated for a longer period of time than the first moving average;
- compare (120; 310) the measured voltage value with a predefined voltage threshold value;
- compare (132; 312) the current value of the first moving average with the current value of the second moving average;
- identify (134; 314) a condition for triggering the protection device when the measured voltage value is below the predefined voltage threshold value for a period of time greater than a predefined time threshold and the current value of the first moving average is greater than the current value of the second moving average.

9. The system according to claim 8, **characterised in that** the electronic monitoring module (22) is integrated into the protection device (20), for example implemented by an electronic trigger of the protection device (20).

10. The system according to claim 8, **characterised in that** the electronic monitoring module (22) is separate from the protection device (20) and mounted outside the protection device (20).

11. An electrical distribution grid (2), in particular a microgrid, comprising:
- an electricity storage device (STOR) and/or an electricity generation device (SOL), supplying a main link (4);
- at least one electrical load, connected to the main link via a protection system according to claim 10.
